# EUROPÄISCHE PATENTSCHRIFT

(11) **EP 2 787 285 B1**
(45) Veröffentlichungstag und Bekanntmachung des Hinweises auf die Patenterteilung: **10.06.2020**
(21) Anmeldenummer: 14162679.6
(22) Anmeldetag: 31.03.2014
(51) Int. Cl.: F24C 15/16, F24C 15/00, C23C 16/40, C23C 16/02, C23C 28/00

(54) **Bauteil für ein Gargerät**
Component for a cooking appliance
Composant pour un appareil de cuisson

(30) Priorität: 05.04.2013 DE 102013206065
(43) Veröffentlichungstag der Anmeldung: 08.10.2014
(73) Patentinhaber: BSH Hausgeräte GmbH, 81739 München (DE)
(72) Erfinder: Bally, Ingo, 83278 Traunstein (DE); Jördens, Frank, 83278 Traunstein (DE); Nather, Philipp, 83071 Stephanskirchen (DE); Sojer, Stefan, 84558 Kirchweidach (DE); Wiedmaier, Matthias, 83301 Traunreut (DE)

(56) Entgegenhaltungen:
- EP-A1- 1 580 299
- EP-A1- 1 607 685
- WO-A1-2012/084733
- WO-A2-2012/085775
- DE-C- 881 596
- US-A- 4 431 708
- US-B1- 6 416 870

## Beschreibung

Die vorliegende Erfindung betrifft ein Bauteil für ein Gargerät, welches in einen Garraum angeordnet ist, sowie ein Verfahren zur Herstellung eines solchen Bauteils.

Aus dem Stand der Technik sind Einhängegitter für Gargeräte bekannt, welche zum Schutz vor Hochtemperatur-Oxidation in Folge von pyrolytischen Selbstreinigungsprozessen eine mittels Gasphasenabscheidung aufgebrachte Siliziumoxidbeschichtung zeigen. Ein Nachteil dieser Lösung ist, dass als Ausgangsmaterial für das Einhängegitter ein rostfreier Stahl benötigt wird, um den chemischen Anforderungen der Oberflächenbeschichtung gerecht zu werden.

Zudem ist aus der WO2012/084733A1 ein Verfahren zum Herstellen eines pyrolysetauglichen Bauteils eines Gargeräts bekannt, welches zur Durchführung eines Pyrolysebetriebs ausgebildet ist, bei welchem ein Grundteil des Bauteils bereitgestellt und beschichtet wird, wobei auf dem Grundteil eine Siliziumdioxidschicht durch eine PECVD-Abscheidung erzeugt wird.

Zudem ist aus der EP 1 607 685 A1 ein Verfahren zur Herstellung eines Teleskopauszugssystems mit Teleskopschienen, vorzugsweise eines Teleskopauszugssystems für Gargutträger in einem Garofen, bekannt, wobei das Grundmaterial des Teleskopauszugssystems Baustahl und/oder Edelstahl ist und welches wenigstens teilweise mit einer auf PTFE (Polytetrafluorethylen) basierenden Beschichtung versehen ist.

Aus der US 6 416 870 B1 ist ein korrosionsbeständiger, multischichtiger Aufbau offenbart, der auch Chrom aufweisen kann.

Aus der US 4 431 708 B1 ist eine Beschichtung bekannt, die auch eine Schwarzchromschicht aufweisen kann.

Aufgabe der Erfindung ist es, eine alternative Herstellungsmethode für ein hochtemperaturfestes Bauteil in einem Gargerät bereitzustellen.

Diese Aufgabe wird durch ein Bauteil für ein Gargerät, welches die Merkmale nach Anspruch 1 aufweist, ein Gargerät, welches die Merkmale nach Anspruch 6 aufweist, und ein Verfahren, welches die Merkmale nach Anspruch 7 aufweist, gelöst.

Ein erfindungsgemäßes Bauteil für ein Gargerät, welches in einem Garraum angeordnet ist, weist eine erste Schutzschicht und eine auf der ersten Schutzschicht aufgebrachte zweie Schutzschicht auf. Dieser mehrschichtige Aufbau des Bauteils ermöglicht eine Oberflächenbehandlung des Grundmaterials, welche insbesondere den Schutz vor Hochtemperatur-Oxidation in Form von Verfärbung sowie Korrosion verbessert.

Erfindungsgemäß besteht das Material des Bauteils für ein Gargerät aus Stahl. Durch die Wahl dieses Werkstoffes ergibt sich eine im Vergleich zu rostfreien Edelstählen eine besonders kostengünstige Variante und eine einfachere Bearbeitung, beim Schweißen oder Biegen.

Die erste Schutzschicht weist eine Chrom-, oder Nickeloberfläche auf, welche auf die metallische Grundfläche des Bauteils aufgebracht ist, und eine Transferschicht bildet, um die zweite Schutzschicht zu tragen. Diese Schutzschicht ist durch bekannte Verfahren, z. B. elektrolytische Abscheidung, aufgebracht. Zudem bildet die erste Schutzschicht, in Form einer Chrom- und/oder Nickelschicht einen Korrosionsschutz des Bauteils.

Erfindungsgemäß ist die zweite Schutzschicht eine Siliziumdioxidschicht. Diese SiO₂-Beschichtung weist eine sehr gute Haftung auf der ersten Schutzschicht auf und besitzt eine hohe Beständigkeit gegenüber Chemikalien sowie Temperatur, wodurch Verfärbungen, Verunreinigungen und Anlassfarben vermieden werden.

Die erste Schutzschicht weist zumindest Abschnittsweise eine Schwarzchromschicht auf. Diese dunkle Färbung des Bauteils hat den Vorteil, dass sich darauf angesammelte Verschmutzungen, welche durch sich durch die Einbrennwirkung dunkel verfärben, im Gegensatz zu einer hellen oder glänzenden Oberfläche, nicht mehr so deutlich absetzen, da die dunkle Oberfläche keinen Kontrast bildet. Dadurch sind Verfleckungen oder eingebrannte Reste, Abriebs- oder Gebrauchsspuren aber auch temperaturbedingte Verfärbungen deutlich weniger sichtbar.

Vorzugsweise ist die Siliziumdioxidschicht durch ein PECVD-Verfahren aufgebracht. Diese plasmagestützte Gasphasenabscheidung unter Vakuum erzeugt eine Silziumdioxidschicht auf der ersten Schutzschicht.

Vorzugsweise ist das Bauteil ein Einhängegitter zur Aufnahme von Backblechen oder Rosten oder eine Teleskopschiene oder Teile eines Teleskopauszugssystems oder ein Rost zur Aufnahme des Garguts.

Des Weiteren wird die Aufgabe durch ein Gargerät, aufweisend ein Bauteil mit einer ersten Schutzschicht und einer auf die erste Schutzschicht aufgebrachte zweite Schutzschicht gelöst.

Darüber hinaus löst die Erfindung die Aufgabe mittels einem Verfahren, wobei auf ein Bauteil eine erste Schutzschicht und eine auf der ersten Schutzschicht aufgebrachten zweiten Schutzschicht erzeugt wird. Dabei wird die auf dem Grundkörper aufgebrachte erste Schutzschicht in Form einer Chrom-/Nickelschicht durch eine mittels PECVD-Abscheidung erzeugte Siliziumdioxidschicht überzogen, um den Schutz vor Hochtemperatur-Oxidation zu verbessern.

Weitere Merkmale der Erfindung ergeben sich aus den Ansprüchen den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalsdefinitionen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind.

Weitere Vorteile und Einzelheiten der Erfindung werden anhand der in den schematischen Figuren dargestellten Ausführungsbeispiele näher erläutert. Ebenso das erfindungsgemäße Verfahren auf Basis dieser Ausführungsbeispiele. Dabei zeigt:
- Fig. 1: eine schematische perspektivische Darstellung eines Ausführungsbeispiels eines erfindungsgemäßen Bauteils für ein Gargerät, in Einbaulage in einem Gargerät;
- Fig. 2: eine schematische perspektivische Darstellung eines ersten Ausführungsbeispiels eines Bauteils für ein Gargerät;
- Fig. 3: eine schematische Darstellung des ersten Ausführungsbeispiels im Querschnitt; und
- Fig. 4: eine schematische perspektivische Darstellung eines zweiten Ausführungsbeispiels eines Bauteils für ein Gargerät.

In den Figuren werden gleiche oder funktionsgleiche Elemente mit den gleichen Bezugszeichen versehen.

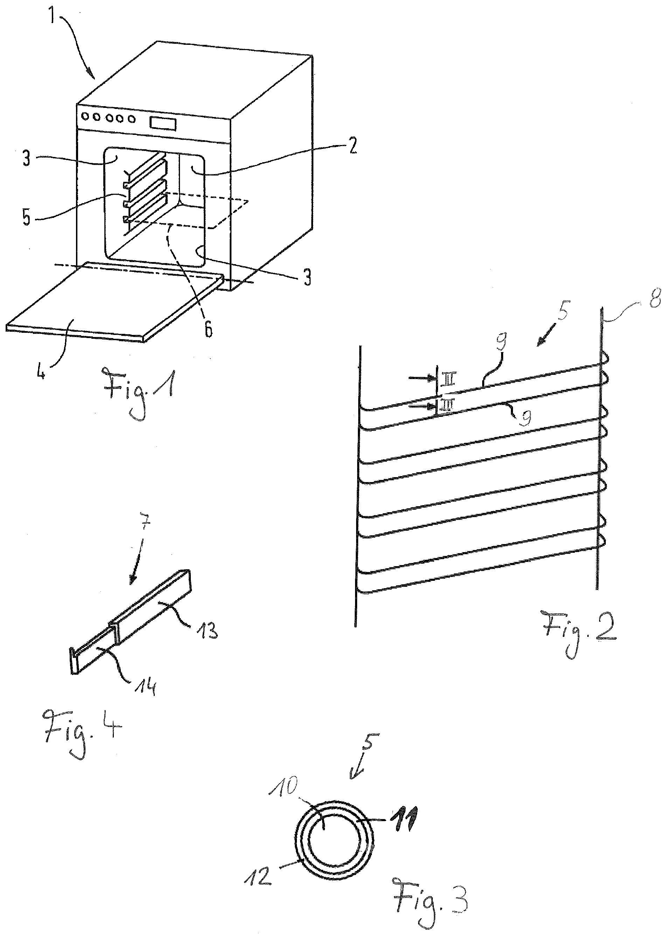

In Fig. 1 ist in einer perspektivischen Darstellung ein Gargerät 1 zum Zubereiten von Lebensmitteln gezeigt, welches im Ausführungsbeispiel ein Backofen ist. Das Gargerät 1 umfasst einen Garraum 2, der durch die Seitenwände 3 des Backrohrs begrenzt ist. Frontseitig weist der Garraum 2 eine Beschickungsöffnung auf, welche durch eine Türe 4 verschließbar ist. An den Seitenwänden 3 befindet sich je ein Einhängegitter 5, das geeignet ist, Gargutträger, wie z. B: Roste 6, Backbleche oder ähnliches Zubehör aufzunehmen. Gemäß einer nicht in Fig. 1 dargestellten Variante befinden sich an der Garraumseitenwand an Stelle des Einhängegitters 5 ein oder mehrere Teleskopauszüge 7. Diese Teleskopauszüge 7 können als Normalauszüge oder Vollauszüge ausgeführt sein.

Fig. 2 zeigt in einer perspektivischen Ansicht das Bauteil eines ersten Ausführungsbeispiels als Einhängegitter 5 zur Aufnahme von Gargutträgern, wie z. B. Roste 6, Bachbleche oder ähnlichem Zubehör. Dieses vereinfacht dargestellte Einhängegitter 5 besteht im Wesentlichen aus zwei parallel angeordneten Haltestäben 8, welche zur Aufnahme der Führungsstäbe 9 an der Garraumseitenwand 3 angeordnet sind. Zudem weist ein Einhängegitter 5 weitere nicht dargestellte Befestigungselemente sowie Abstandshalter auf. Bei den Haltestäben 8 sowie den Führungsstäben 9 handelt es sich in der Regel um Drahtware, welche in Biege- und Schweißprozessen zu einem Einhängegitter verarbeitet wird. Aufgrund dieser Herstellungsvariante sowie den hohen Temperaturanforderungen während des bestimmungsgemäßen Backprozesses und pyrolytischen Selbstreinigungsprozessen ist als Grundmaterial der Einhängegitter Stahl besonders geeignet. Dieses Grundmaterial unterliegt jedoch einer starken Verfärbung durch Hochtemperatur-Oxidation, in Form von Anlassfarben.

Fig. 3 zeigt den Querschnitt eines Einhängegitters 5 im Bereich des Haltestabs 8 oder des Führungsstabs 9. Zur Vermeidung von Verfärbungen durch Hochtemperatur-Oxidation oder Verschmutzungen, erhält das Grundmaterial 10 des Einhängegitters 5 eine erste Schutzschicht 11 und eine auf der ersten Schutzschicht 11 aufgebrachte zweite Schutzschicht 12. Dabei besteht die erste Schutzschicht 11 aus einer auf den metallischen Grundkörper 10 aufgebrachten Chrom-, Chromnickel oder Nickelbeschichtung. Die zweite Schutzschicht 12 besteht aus einer SiO₂-Schicht, welche durch eine plasmagestützte Gasphasenabscheidung, vorzugsweise unter Vakuum aufgebracht ist.

Fig. 4 zeigt in einer perspektivischen Ansicht das Bauteil eines zweiten Ausführungsbeispiels als Teleskopauszug zur Aufnahme von Gargutträgern. Dieser Teleskopauszug 7 stellt eine alternative Ausführungsform des Bauteils für ein Gargerät dar. Ein Teleskopauszug 7 besteht im Wesentlichen aus einer Festschiene 13, welche starr oder adaptierbar an einem Einhängegitter befestigt oder starr oder adaptierbar an einer Garraumseitenwand 3 angebracht ist. Diese Festschiene 13 ist im Wesentlichen durch nicht dargestellte Roll- oder Gleitkörper dazu geeignet, Laufschienen 14 aufzunehmen und teleskopartig in Auszugsrichtung zu bewegen. Die Oberflächen der Teleskopauszüge 7 unterliegen den gleichen Anforderungen wie voran beschriebene Oberflächen der Einhängegitter 5. Zur Vermeidung von Hochtemperatur-Oxidation, Verfärbungen, Korrosion oder anhaftenden Schmutz erfahren zumindest Abschnitte der Teleskopauszüge 7 eine voran beschriebene mehrteilige Beschichtung. Dabei wird der Grundkörper der Festschiene 13 und / oder Grundkörper der Laufschiene 14 mit einer ersten Schutzschicht 11 und mit einer auf die erste Schutzschicht 11 aufgebrachten zweiten Schutzschicht 12 beschichtet.

## Patentansprüche

1. Bauteil für ein Gargerät (1), welches in einem Garraum (2) angeordnet ist, wobei ein Grundmaterial (10) des Bauteils Stahl ist und das Bauteil eine erste Schutzschicht (11) und eine auf der ersten Schutzschicht (11) aufgebrachte zweite Schutzschicht (12) aufweist, wobei die zweite Schutzschicht (12) eine Siliziumdioxidschicht aufweist, **dadurch gekennzeichnet, dass** die erste Schutzschicht (11) eine Chromschicht und/oder eine Nickelschicht aufweist und die erste Schutzschicht (11) zumindest Abschnittsweise eine Schwarzchromschicht aufweist.

2. Bauteil nach dem vorhergehenden Anspruch, **dadurch gekennzeichnet, dass** die Siliziumdioxidschicht durch ein PECVD-Verfahren, insbesondere Hochrate-PECVD-Abscheiden, auf das Bauteil aufgebracht ist.

3. Bauteil nach einem der vorhergehenden Ansprüche, **dadurch gekennzeichnet, dass** das Bauteil ein Einhängegitter zur Aufnahme von Backblechen oder Rosten (6) ist.

4. Bauteil nach einem der vorhergehenden Ansprüche, **dadurch gekennzeichnet, dass** das Bauteil eine Teleskopschiene (7) ist.

5. Bauteil nach einem der vorhergehenden Ansprüche, **dadurch gekennzeichnet, dass** das Bauteil ein Rost (6) zur Aufnahme des Garguts ist.

6. Gargerät (1), aufweisend ein Bauteil nach einem der vorhergehenden Ansprüche 1 bis 5.

7. Verfahren zur Herstellung eines Bauteils für ein Gargerät, wobei ein Grundmaterial (10) des Bauteils Stahl ist und auf das Bauteil eine erste Schutzschicht (11) und eine auf der ersten Schutzschicht (11) aufgebrachte zweite Schutzschicht (12) aufgebracht wird, wobei die zweite Schutzschicht (12) eine Siliziumdioxidschicht aufweist, **dadurch gekennzeichnet, dass** die erste Schutzschicht (11) als eine Chromschicht und/oder eine Nickelschicht aufgebracht wird und die erste Schutzschicht (11) zumindest Abschnittsweise als eine Schwarzchromschicht aufgebracht wird.

## Claims

1. Component for a cooking appliance (1), which is arranged in a cooking compartment (2), wherein a base material (10) of the component is steel and the component has a first protective layer (11) and a second protective layer (12) applied to the first protective layer (11), wherein the second protective layer (12) has a silicon dioxide layer, **characterised in that** the first protective layer (11) has a chrome layer and/or a nickel layer and the first protective layer (11) has a black chrome layer at least in sections.

2. Component according to the preceding claim, **characterised in that** the silicon dioxide layer is applied to the component by means of a PECVD method, in particular high rate PECVD deposition.

3. Component according to one of the preceding claims, **characterised in that** the component is a wire shelf for receiving baking trays or grills (6).

4. Component according to one of the preceding claims, **characterised in that** the component is a telescopic rail (7).

5. Component according to one of the preceding claims, **characterised in that** the component is a grill (6) for receiving the food.

6. Cooking appliance (1), having a component according to one of the preceding claims 1 to 5.

7. Method for producing a component for a cooking appliance, wherein a base material (10) of the component is steel and a first protective layer (11) and a second protective layer (12) applied to the first protective layer (11) is applied to the component, wherein the second protective layer (12) has a silicon dioxide layer, **characterised in that** the first protective layer (11) is applied as a chrome layer and/or a nickel layer and the first protective layer (11) is applied as a black chrome layer at least in sections.

## Revendications

1. Composant pour un appareil de cuisson (1), qui est disposé dans un espace de cuisson (2), dans lequel un matériau de base (10) du composant est l'acier et le composant présente une première couche de protection (11) et une deuxième couche de protection (12) apposée sur la première couche de protection (11), dans lequel la deuxième couche de protection (12) présente une couche de dioxyde de silicium, **caractérisé en ce que** la première couche de protection (11) présente une couche de chrome et/ou une couche de nickel et la première couche de protection (11) présente au moins par sections une couche de chrome noir.

2. Composant selon la revendication précédente, **caractérisé en ce que** la couche de dioxyde de silicium est apposée sur le composant via un procédé PECVD, en particulier un dépôt PECVD à taux élevé.

3. Composant selon l'une des revendications précédentes, **caractérisé en ce que** le composant est une grille à suspendre pour l'accueil de plaques de cuisson ou de grilles (6).

4. Composant selon l'une des revendications précédentes, **caractérisé en ce que** le composant est un rail télescopique (7).

5. Composant selon l'une des revendications précédentes, **caractérisé en ce que** le composant est une grille (6) pour l'accueil des denrées à cuire.

6. Appareil de cuisson (1) présentant un composant selon l'une des revendications précédentes 1 à 5.

7. Procédé de fabrication d'un composant pour un appareil de cuisson, dans lequel un matériau de base (10) du composant est l'acier et une première couche de protection (11) et une deuxième couche de protection (12) apposée sur la première couche de protection (11) sont apposées sur le composant, dans lequel la deuxième couche de protection (12) présente une couche de dioxyde de silicium, **caractérisé en ce que** la première couche de protection (11) est apposée sous la forme d'une couche de chrome et/ou d'une couche de nickel et la première couche de protection (11) est apposée au moins par sections sous la forme d'une couche de chrome noir.
